# EUROPÄISCHE PATENTSCHRIFT

(11) **EP 3 827 312 B1**
(45) Veröffentlichungstag und Bekanntmachung des Hinweises auf die Patenterteilung: **05.07.2023**
(21) Anmeldenummer: 19727876.5
(22) Anmeldetag: 16.05.2019
(51) Int. Cl.: G03F 7/20, G02B 7/00, G02B 7/18, G01J 5/08

(54) **VERFAHREN UND VORRICHTUNG ZUM BESTIMMEN DES ERWÄRMUNGSZUSTANDES EINES OPTISCHEN ELEMENTS IN EINEM OPTISCHEN SYSTEM FÜR DIE MIKROLITHOGRAPHIE**
METHOD AND DEVICE FOR DETERMINING THE HEATING STATE OF AN OPTICAL ELEMENT IN AN OPTICAL SYSTEM FOR MICROLITHOGRAPHY
PROCÉDÉ ET DISPOSITIF POUR LA DÉTERMINATION DE LA CONDITION DE CHAUFFAGE D'UN ÉLÉMENT OPTIQUE DANS UN SYSTÈME OPTIQUE POUR LA MICROLITHOGRAPHIE

(30) Priorität: 25.07.2018 DE 102018212400
(43) Veröffentlichungstag der Anmeldung: 02.06.2021
(60) Teilanmeldung: 23156248.9
(73) Patentinhaber: Carl Zeiss SMT GmbH, 73447 Oberkochen (DE)
(72) Erfinder: GRUNER, Toralf, 73433 Aalen (DE); HARTJES, Joachim, 73433 Aalen (DE); HAUF, Markus, 89075 Ulm (DE); BEURER, Gerhard, 89073 Ulm (DE)
(74) Vertreter: Frank, Hartmut
(86) Internationale Anmeldenummer: PCT/EP2019/062631
(87) Internationale Veröffentlichungsnummer: WO 2020/020506

(56) Entgegenhaltungen:
- DE-A1-102005 004 460
- DE-A1-102011 081 259
- DE-A1-102018 207 126
- JP-A- H02 181 416
- US-A1- 2012 127 440

## Beschreibung

### HINTERGRUND DER ERFINDUNG

### Gebiet der Erfindung

Die Erfindung betrifft ein Verfahren zum Bestimmen des Erwärmungszustandes eines optischen Elements in einem optischen System für die Mikrolithographie sowie ein optisches System für die Mikrolithographie, umfassend eine Vorrichtung zum Bestimmen des Erwärmungszustandes eines optischen Elements.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Ein in der Praxis auftretendes Problem ist, dass die EUV-Spiegel u.a. infolge Absorption der von der EUV-Lichtquelle emittierten Strahlung eine Erwärmung und eine damit einhergehende thermische Ausdehnung bzw. Deformation erfahren, welche wiederum eine Beeinträchtigung der Abbildungseigenschaften des optischen Systems zur Folge haben kann.

Zur Berücksichtigung dieses Effekts ist es u.a. bekannt, als Spiegelsubstratmaterial ein Material mit ultraniedriger thermischer Expansion ("Ultra-Low-Expansion-Material"), z.B. ein unter der Bezeichnung ULE^{™} von der Firma Corning Inc. vertriebenes Titanium-Silicatglas, zu verwenden und in einem der optischen Wirkfläche nahen Bereich die sogenannte Nulldurchgangstemperatur (= "Zero-Crossing-Temperatur") einzustellen. Bei dieser Zero-Crossing-Temperatur, welche z.B. für ULE^{™} bei etwa 9= 30°C liegt, weist der thermische Ausdehnungskoeffizient in seiner Temperaturabhängigkeit einen Nulldurchgang auf, in dessen Umgebung keine oder nur eine vernachlässigbare thermische Ausdehnung des Spiegelsubstratmaterials erfolgt.

Hierbei tritt jedoch in der Praxis das Problem auf, dass ein EUV-Spiegel im Betrieb der mikrolithographischen Projektionsbelichtungsanlage wechselnden Intensitäten der auftreffenden elektromagnetischen Strahlung ausgesetzt ist, und zwar sowohl in örtlicher Hinsicht z.B. aufgrund der Verwendung von Beleuchtungssettings mit über die optische Wirkfläche des jeweiligen EUV-Spielgels variierender Intensität, als auch in zeitlicher Hinsicht, wobei sich der betreffende EUV-Spiegel insbesondere zu Beginn des mikrolithographischen Belichtungsprozesses typischerweise von einer vergleichsweise niedrigeren Temperatur auf seine im Lithographieprozess erreichte Betriebstemperatur aufheizt.

Ein Ansatz zur Überwindung des vorstehend beschriebenen Problems und insbesondere zur Vermeidung von durch variierende Wärmeeinträge in einen EUV-Spiegel verursachten Oberflächendeformationen und damit einhergehenden optischen Aberrationen beinhaltet den Einsatz von Vorheizern z.B. auf Basis von Infrarotstrahlung. Mit solchen Vorheizern kann in Phasen vergleichsweise geringer Absorption von EUV-Nutzstrahlung eine aktive Spiegelerwärmung erfolgen, wobei diese aktive Spiegelerwärmung mit steigender Absorption der EUV-Nutzstrahlung entsprechend zurückgefahren wird.

Eine mit dem Ziel der Aufrechterhaltung einer möglichst konstanten Spiegeltemperatur (typischerweise der o.g. Nulldurchgangstemperatur) durchgeführte Regelung des Betriebs solcher Vorheizer erfordert die Kenntnis der jeweils auf dem betreffenden Spiegel auftreffenden Strahlungsleistung, damit die Vorheizleistung entsprechend angepasst werden kann. Hierzu finden (neben aus Bauraumgründen nicht immer praktikablen Infrarotkameras) Temperatursensoren etwa in Form von Thermoelementen oder auf dem elektrischen Widerstand basierenden (z.B. NTC-) Temperatursensoren Anwendung, welche typischerweise kraft- oder stoffschlüssig an unterschiedlichen Positionen des jeweiligen Spiegels angebracht werden können.

Durch die Anbringung solcher Thermoelemente können jedoch zum einen unerwünschte mechanische Spannungen in das Spiegelsubstrat induziert werden, wobei zum anderen auch - insbesondere wenn zur Ermittlung einer räumlich variierenden Temperaturverteilung innerhalb des Spiegels eine Vielzahl von Temperatursensoren benötigt werden - der Fertigungsaufwand signifikant erhöht sowie gegebenenfalls die mechanische Stabilität des Spiegels beeinträchtigt wird.

DE 10 2005 004 460 A1 offenbart u.a. ein Verfahren und ein zugehöriges Messsystem zur indirekten Bestimmung der Bestrahlungsstärke auf einer Komponente eines optischen Systems. Zur ortsaufgelösten Messung des Aufheizens einer optischen Komponente wird mit Temperaturdetektoren (z.B. berührungslose Infrarotsensitive CCD-Kamerasysteme oder scannend arbeitende Einzeldetektoren) die Temperaturverteilung auf der optischen Komponente bestimmt. Hieraus können u.a. Deformationen der optischen Komponente abgeschätzt und die Ausbildung einer adaptiven Optik ermöglicht werden.

JP H02 181416 A offenbart u.a. ein Verfahren zur Optimierung der Temperaturverteilung in einem eine Mehrzahl von Linsen aufweisenden Objektiv während des Bestrahlungsvorgangs. Die Messung der Bestrahlungsstärke erfolgt über eine außerhalb der Linsen angeordnete Temperaturerfassungseinheit mit einem für jede Linse zugeordneten Wärmestrahlungstemperatursensor. Aufgrund des erfassten Wertes kann eine Änderung der Temperatur durchgeführt werden.

US 2012/127440 A1 offenbart u.a. ein Messverfahren zur Bestimmung der lokalen Temperaturverteilung eines Substrats. Die Messung erfolgt durch eine Fluoreszenzanregung in einem bestimmten Volumen im Substrat, welches fluoreszierende Bestandteile enthält. Ausgehend von einer Anregungs-Lichtquelle werden die Strahlen über eine Fluoreszenzoptik und eine Anregungsoptik in das für die Messung bestimmte Volumen geführt, wobei das hier erzeugte Fluoreszenzlicht von einem außerhalb des Substrats liegenden Fluoreszenzlicht-Detektor erfasst wird.

DE 10 2018 207 126 A1 offenbart u.a. eine Vorrichtung zur Bestimmung der Temperaturverteilung auf einer optischen Fläche. Im Volumen des optischen Elements ist ein Kanal eingebracht, in dem ein beweglicher Temperatursensor mit einer elektrischen Leitung angeordnet ist.

DE 10 2011 081 259 A1 offenbart u.a. eine Anordnung zur Spiegeltemperaturmessung. Im Spiegelsubstrat befindet sich ein Zugangskanal, in den ein Rohr eingebracht ist, an dessen Endabschnitt außerhalb des Spiegels ein Sensor angebracht ist, über den die Temperaturänderung an der Stirnfläche des Zugangskanals über sich entlang des Zugangskanal ausbreitende elektromagnetische Strahlung ermittelt wird.

Zum weiteren Stand der Technik wird lediglich beispielhaft auf DE 36 05 737 A1 verwiesen.

### ZUSAMMENFASSUNG DER ERFINDUNG

Es ist eine Aufgabe der vorliegenden Erfindung, ein Verfahren und eine Vorrichtung zum Bestimmen des Erwärmungszustandes eines optischen Elements in einem optischen System für die Mikrolithographie bereitzustellen, welche unter Vermeidung der vorstehend beschriebenen Probleme eine möglichst genaue Kenntnis des Erwärmungszustandes ermöglichen.

Diese Aufgabe wird durch das Verfahren gemäß den Merkmalen des unabhängigen Patentanspruchs 1 sowie die Vorrichtung gemäß den Merkmalen des nebengeordneten Patentanspruchs 12 gelöst.

Bei einem erfindungsgemäßen Verfahren zum Bestimmen des Erwärmungszustandes eines optischen Elements in einem optischen System für die Mikrolithographie wird wenigstens ein berührungsloser, auf dem Empfang elektromagnetischer Strahlung von dem optischen Element basierender Sensor verwendet, wobei zur Ermittlung einer Temperaturverteilung in dem optischen Element der von dem Sensor erfasste Strahlungsbereich variiert wird.

Das Verfahren ist dadurch gekennzeichnet, dass die Variation unter Verwendung einer zwischen dem optischen Element und dem Sensor befindlichen Strahlformungsoptik erfolgt.

Der Erfindung liegt insbesondere das Konzept zugrunde, eine berührungslose Bestimmung des Erwärmungszustandes eines optischen Elements für die Lithographie unter Verwendung eines auf dem Empfang von elektromagnetischer Strahlung bzw. Wärmestrahlung von dem optischen Element basierenden, berührungslosen Sensors zu realisieren. Dabei wird erfindungsgemäß bewusst auf eine - beispielsweise mit am Spiegel angebrachten Thermoelementen oder NTC-Sensoren mögliche - punktgenaue Temperaturmessung verzichtet und zudem auch ein u.U. erhöhter apparativer Aufwand und gesteigerter Bauraumbedarf etwa für den Einsatz eines Pyrometers in Kauf genommen.

Im Gegenzug wird erfindungsgemäß zum einen der mit dem herkömmlichen Einsatz z.B. besagter Thermoelemente oder NTC-Sensoren einhergehende Eintrag mechanischer Spannungen in das optische Element bzw. den Spiegel vermieden. Zum anderen kann auch - wie im Weiteren noch näher erläutert - das erfindungsgemäße Konzept des Einsatzes eines berührungslosen strahlungsbasierten Sensors in Verbindung mit einer - in unterschiedlichen Ausführungsformen realisierbaren - Variation des von diesem Sensor erfassten Strahlungsbereichs dazu genutzt werden, eine (typischerweise örtlich variierende) Temperaturverteilung im optischen Element zu ermitteln, wobei aufgrund besagter (z.B. wie im Weiteren beschrieben optisch und/oder mechanisch erzielbarer) "zonaler Abtastung" des optischen Elements diese Temperaturverteilung bereits mit einem oder nur wenigen berührungslosen Sensoren ermittelt werden kann.

Infolge des erfindungsgemäßen Einsatzes eines berührungslosen strahlungsbasierten Sensors ist es grundsätzlich möglich, auf jegliche mechanische Manipulation an dem hinsichtlich seines Erwärmungszustandes zu vermessenden optischen Element vollständig zu verzichten. In weiteren Ausführungsformen der Erfindung ist es jedoch auch möglich, zusätzlich die Geometrie einer oder mehrerer (insbesondere brechender) Flächen am optischen Element (z.B. an einer Spiegelrückseite) zielgerichtet auszugestalten, um beispielsweise in Kombination mit einer in Bezug auf den Spiegel lateralen und/oder axialen Bewegung des berührungslosen strahlungsbasierten Sensors den Prozess der zonalen Abtastung des Spiegels in geeigneter Weise zusätzlich zu unterstützen. Insbesondere kann gemäß der Erfindung auf der dem Sensor zugewandten Seite wenigstens eine Aussparung oder Vertiefung und/oder wenigstens eine erhabene Struktur im optischen Element vorgesehen sein mit der Folge, dass z.B. in Verbindung mit einer lateralen Bewegung des berührungslosen strahlungsbasierten Sensors (Wärme-) Strahlung aus unterschiedlichen "Höhenlagen" des optischen Elements zum Sensor gelangt.

Grundsätzlich stellt das von dem erfindungsgemäßen berührungslosen Sensor erfasste Signal - im Gegensatz zu der etwa mit einem Thermoelement oder einem NTC-Temperatursensor erhaltenen, im Wesentlichen punktgenauen Information - ein Überlagerungssignal aus den Beiträgen unterschiedlicher Bereiche des optischen Elements dar. Dennoch kann erfindungsgemäß anhand einer Simulation und/oder durch Vergleich mit vorab durchgeführten Kalibriermessungen sowie modellbasiert eine räumliche Temperaturverteilung im optischen Element mit hoher örtlicher Auflösung ermittelt werden.

Gemäß der Erfindung erfolgt die Variation des von dem Sensor erfassten Strahlungsbereichs unter Verwendung einer zwischen dem optischen Element und dem Sensor befindlichen Strahlformungsoptik. Durch diese Variation kann eine zonale Abtastung des optischen Elements realisiert werden.

Gemäß einer Ausführungsform weist die Strahlformungsoptik ein Zoom-Axikon-System auf. In weiteren Ausführungsformen der Strahlformungsoptik können zwischen dem optischen Element und dem berührungslosen Sensor zur Variation des vom Sensor erfassten Strahlungsbereichs auch ein oder mehrere (insbesondere auch relativ zueinander) verschiebbar und/oder drehbar angeordnete optische Elemente geeigneter (z.B. keilförmiger oder zylindrischer) Geometrie verwendet werden.

Gemäß einer Ausführungsform umfasst die Variation des von dem Sensor erfassten Strahlungsbereichs eine Manipulation der Relativposition zwischen dem optischen Element und dem Sensor.

Gemäß einer Ausführungsform ist das optische Element ein Spiegel.

Gemäß einer Ausführungsform ist das optische Element für eine Arbeitswellenlänge von weniger als 30nm, insbesondere weniger als 15nm, ausgelegt.

Gemäß einer Ausführungsform wird auf Basis der Bestimmung des Erwärmungszustandes eine Vorheizung des optischen Elements zur wenigstens teilweisen Kompensation von im Betrieb des optischen Systems auftretenden zeitlichen Änderungen des Erwärmungszustandes des optischen Elements durchgeführt. In weiteren Ausführungsformen kann auch eine Kompensation von durch den Erwärmungszustand im optischen System hervorgerufenen optischen Aberrationen durch geeignete Manipulatoren (z.B. adaptive Spiegel) erfolgen. Dabei können auch alternativ oder zusätzlich entsprechend kompensierende Änderungen des Gasdrucks, der Bestrahlungsintensität, der Bestrahlungswellenlänge und/oder des Beleuchtungssettings im jeweiligen optischen System vorgenommen werden. Gemäß einer Ausführungsform wird die Bestimmung des Erwärmungszustandes während des Betriebs des optischen Systems (z.B. einer mikrolithographischen Projektionsbelichtungsanlage) durchgeführt.

Die Erfindung betrifft weiter ein optisches System für die Mikrolithographie, umfassend eine Vorrichtung zur Bestimmung des Erwärmungszustandes eines optischen Elements, insbesondere in einer mikrolithographischen Projektionsbelichtungsanlage, wobei die Vorrichtung wenigstens einen berührungslosen, auf dem Empfang elektromagnetischer Strahlung von dem optischen Element basierenden Sensor und eine Einrichtung zur Variation des von dem Sensor erfassten Strahlungsbereichs aufweist, und wobei die Vorrichtung zur Durchführung eines Verfahrens mit den vorstehend beschriebenen Merkmalen ausgestaltet ist. Zu Vorteilen und bevorzugten Ausgestaltungen der Vorrichtung wird auf die o.g. Ausführungen im Zusammenhang mit dem erfindungsgemäßen Verfahren Bezug genommen.

Weitere Ausgestaltungen der Erfindung sind der Beschreibung sowie den Unteransprüchen zu entnehmen. Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung des möglichen Aufbaus einer für den Betrieb im EUV ausgelegten mikrolithographischen Projektionsbelichtungsanlage; und
- Figur 2-6: schematische Darstellungen zur Erläuterung möglicher Ausführungsformen des erfindungsgemäßen Verfahrens bzw. der Vorrichtung.

### DETAILLIERTE BESCHREIBUNG BEVORZUGTER AUSFÜHRUNGSFORMEN

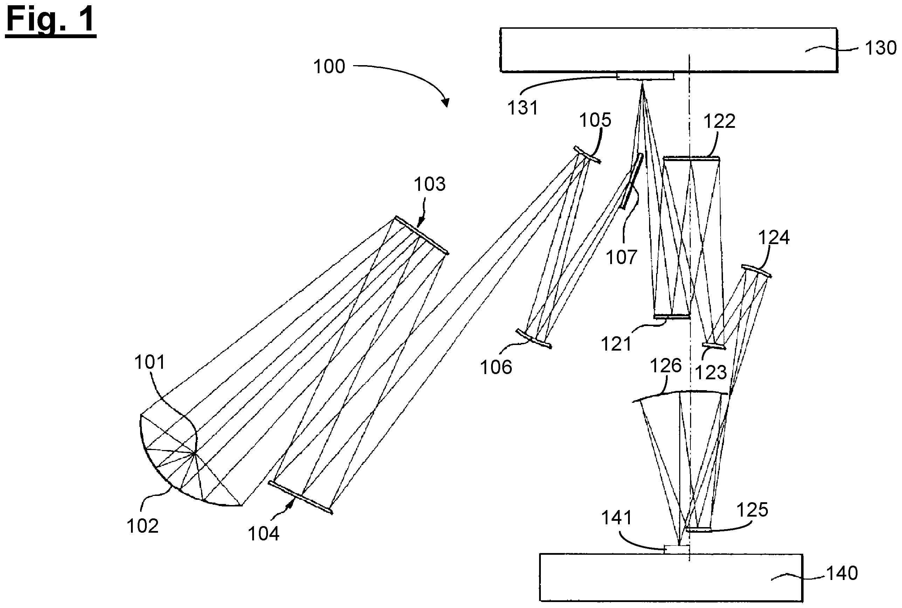

Fig. 1 zeigt eine schematische Darstellung einer für den Betrieb im EUV ausgelegten Projektionsbelichtungsanlage 100, in der die Erfindung beispielsweise realisierbar ist.

Gemäß Fig. 1 weist eine Beleuchtungseinrichtung der Projektionsbelichtungsanlage 100 einen Feldfacettenspiegel 103 und einen Pupillenfacettenspiegel 104 auf. Auf den Feldfacettenspiegel 103 wird das Licht einer Lichtquelleneinheit, welche im Beispiel eine EUV-Lichtquelle (Plasmalichtquelle) 101 und einen Kollektorspiegel 102 umfasst, gelenkt. Im Lichtweg nach dem Pupillenfacettenspiegel 104 sind ein erster Teleskopspiegel 105 und ein zweiter Teleskopspiegel 106 angeordnet. Im Lichtweg nachfolgend ist ein Umlenkspiegel 107 angeordnet, der die auf ihn treffende Strahlung auf ein Objektfeld in der Objektebene eines sechs Spiegel 121-126 umfassenden Projektionsobjektivs lenkt. Am Ort des Objektfeldes ist eine reflektive strukturtragende Maske 131 auf einem Maskentisch 130 angeordnet, die mit Hilfe des Projektionsobjektivs in eine Bildebene abgebildet wird, in welcher sich ein mit einer lichtempfindlichen Schicht (Photoresist) beschichtetes Substrat 141 auf einem Wafertisch 140 befindet.

Im Betrieb der mikrolithographischen Projektionsbelichtungsanlage 100 wird die auf die optische Wirkfläche bzw. Auftrefffläche der vorhandenen Spiegel auftreffende elektromagnetische Strahlung zum Teil absorbiert und führt wie eingangs erläutert zu einer Erwärmung und einer damit einhergehenden thermischen Ausdehnung bzw. Deformation, welche wiederum eine Beeinträchtigung der Abbildungseigenschaften zur Folge haben kann.

Das erfindungsgemäße Verfahren bzw. die erfindungsgemäße Vorrichtung zum Bestimmen des Erwärmungszustandes eines optischen Elements können insbesondere z.B. auf einen beliebigen Spiegel der mikrolithographischen Projektionsbelichtungsanlage 100 von Fig. 1 angewendet werden.

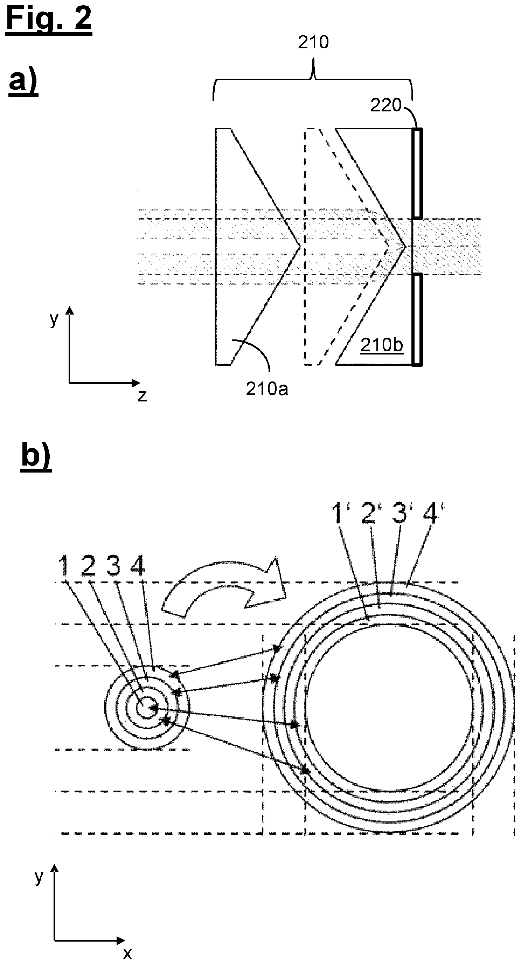

Im Weiteren werden unterschiedliche Ausführungsformen des erfindungsgemäßen Verfahrens bzw. der Vorrichtung unter Bezugnahme auf die schematischen Abbildungen in Fig. 2 bis 6 beschrieben. Diesen Ausführungsformen ist gemeinsam, dass jeweils wenigstens ein berührungsloser strahlungsbasierter Sensor zur Bestimmung des Erwärmungszustandes verwendet wird.

Wenngleich dieser berührungslose Sensor in den im Weiteren beschriebenen Ausführungsbeispielen jeweils als Pyrometer realisiert ist, ist die Erfindung nicht hierauf beschränkt. In weiteren Ausführungsformen können auch andere geeignete berührungslose strahlungsbasierte Sensoren wie z.B. IR-Photodioden oder Photomultiplier verwendet werden.

Des Weiteren wird bei den im Folgenden anhand von Fig. 2 bis 6 beschriebenen Ausführungsformen jeweils in Kombination mit dem erfindungsgemäß eingesetzten berührungslosen strahlungsbasierten Sensor eine Variation des von dem betreffenden Sensor erfassten Strahlungsbereichs vorgenommen, um im Wege einer zonalen Abtastung des hinsichtlich des Erwärmungszustandes zu vermessenden optischen Elements eine typischerweise örtlich variierende Temperaturverteilung innerhalb des optischen Elements zu ermitteln.

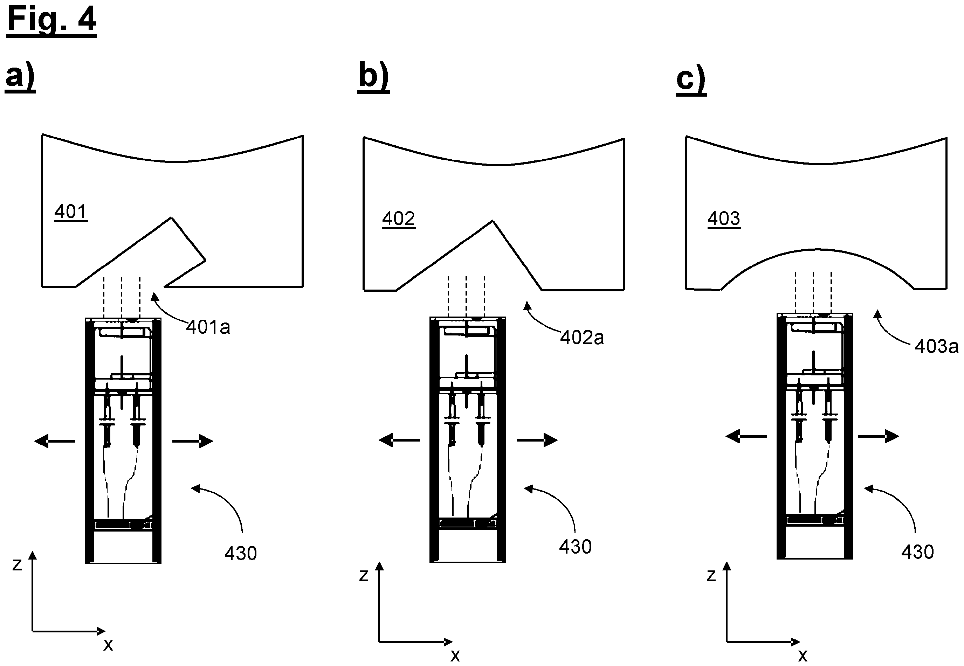

Die vorstehend beschriebene Variation des Strahlungsbereichs kann gemäß der Ausführungsform von Fig. 2 bis Fig. 3a-3b optisch über eine geeignete Vorschaltoptik und zusätzlich gemäß Fig. 4 bis Fig. 6 mechanisch bzw. unter Manipulation der Relativposition zwischen dem optischen Element und dem berührungslosen strahlungsbasierten Sensor erfolgen.

Die Erfindung ist nicht auf die in Fig. 2 bis 6 dargestellten Ausführungsformen beschränkt.

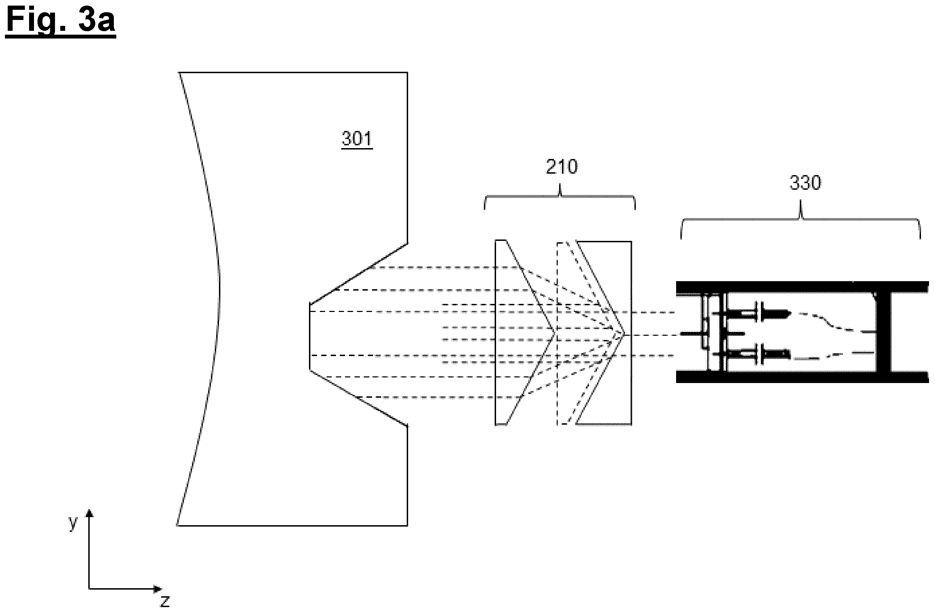

Unter erneuter Bezugnahme auf Fig. 2 bis Fig. 3a-3b befindet sich in einem ersten Ausführungsbeispiel zwischen einem hinsichtlich seines Erwärmungszustandes zu vermessenden optischen Element 301 in Form eines Spiegels und einem im Ausführungsbeispiel als Pyrometer ausgestalten berührungslosen strahlungsbasierten Sensor 330 ein Zoom-Axikon-System 210, durch dessen (in Fig. 3a gestrichelt angedeutete) Verstellung erreicht wird, dass die gemäß Fig. 3a am berührungslosen Sensor bzw. Pyrometer 330 eintreffende (Wärme-) Strahlung von unterschiedlichen (im Beispiel gemäß Fig. 2b ringförmigen) Bereichen des optischen Elements 301 stammt, wobei diese Bereiche für zwei unterschiedliche Einstellungen des Zoom-Axikon-Systems in Fig. 2b mit "1" bis "4" bzw. "1‴ bis "4‴ bezeichnet sind.

Infolge der vorstehend beschriebenen Funktionsweise der durch das Zoom-Axikon-System gebildeten Vorschaltoptik wird eine zonale Abtastung des optischen Elements 301 und somit eine Ermittlung der typischerweise räumlich variierenden Temperaturverteilung in diesem Element 301 bereits mit einem einzigen berührungslosen Sensor 330 (oder zumindest unter Verwendung nur weniger Sensoren) ermöglicht, da die besagte Vorschaltoptik eine kontinuierliche Variation des vom Sensor erfassten Strahlungsbereichs ermöglicht. Mit anderen Worten wird erfindungsgemäß erreicht, dass mit ein- und demselben Sensor 330 in einem Scanvorgang unterschiedliche Bereiche des optischen Elements 301 hinsichtlich ihres Erwärmungszustandes bzw. der jeweils ausgesandten Wärmestrahlung erfasst und auf den Sensor 330 projiziert werden.

In weiteren Ausführungsformen kann eine zwischen dem optischen Element 301 und dem berührungslosen Sensor 330 zur Variation des vom Sensor 330 erfassten Strahlungsbereichs eingesetzte variable (Vorschalt-)Optik auch in anderer geeigneter Weise, z.B. durch ein oder mehrere verschiebbar und/oder drehbar angeordnete optische Elemente (sog. "Alvarez"-Elemente) mit geeignet gekrümmter optisch brechender Fläche (z.B. von keilförmiger oder zylindrischer Geometrie) realisiert werden. Des Weiteren können besagte Elemente auch mit einer verschiebbaren und/oder drehbaren Blende (in Fig. 2a angedeutet und mit "220" bezeichnet) kombiniert werden, um den jeweils hinsichtlich der detektierten Strahlung erfassten Bereich des optischen Elements 301 einzugrenzen.

Im Ausführungsbeispiel gemäß Fig. 3a weist das optische Element 301 bzw. der Spiegel auf seiner dem Sensor 330 zugewandten Rückseite eine kegelförmige Bohrung auf. Weitere Ausführungsformen solcher Bohrungen, Ausnehmungen oder Vertiefungen am optischen Element werden anhand von Fig. 4 bis 6 noch beschrieben. Die Erfindung ist jedoch nicht auf deren konkrete Ausgestaltung oder überhaupt auf das Vorhandensein von Bohrungen, Ausnehmungen oder Vertiefungen am optischen Element beschränkt.

Wenngleich in der Ausführungsform von Fig. 3a die von dem Sensor 330 erfasste Strahlung sowohl auf das Zoom-Axikon-System 210 als auch auf den Sensor 330 parallel zur (entlang der z-Achse im eingezeichneten Koordinatensystem verlaufenden) optischen Achse trifft, ist die Erfindung nicht hierauf beschränkt. So kann in weiteren Ausführungsformen durch entsprechende Anpassung der Komponenten des Zoom-Axikon-Systems 310 auch ein abweichender, z.B. divergenter Strahlungsverlauf realisiert werden.

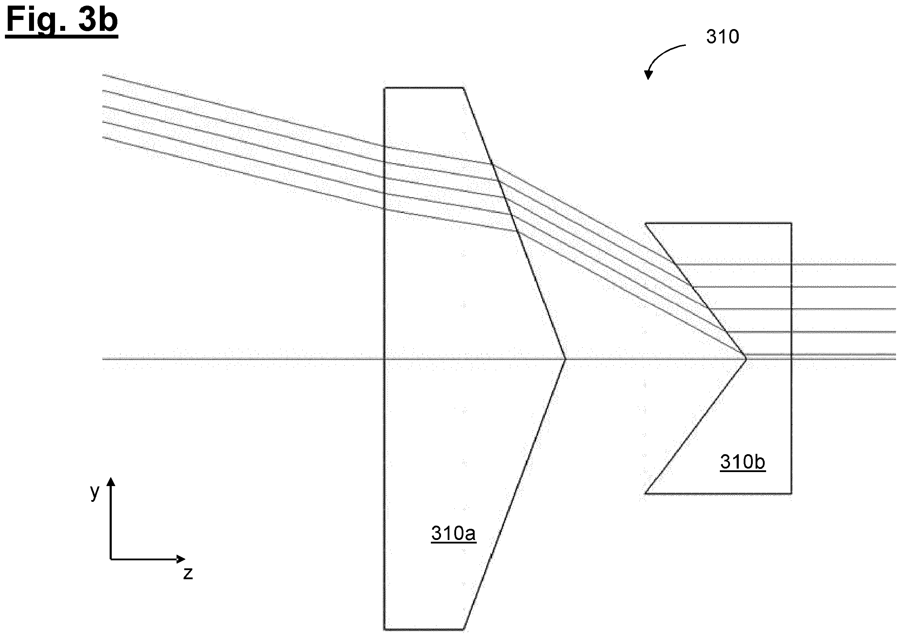

Fig. 3b zeigt eine mögliche weitere Ausgestaltung eines Zoom-Axikon-Systems 310, bei welcher auf eine kegelförmige Bohrung oder anderweitig abgeschrägte Rückseite des optischen Elements verzichtet werden kann. Hierzu wird bei den beiden Elementen 310a, 310b des Zoom-Axikon-Systems 310 gezielt von einer zueinander komplementären Form durch unterschiedliche Winkel vom Apex oder durch eine angepasste Krümmung des Querschnitts an wenigstens einem der Elemente 310a, 310b des Zoom-Axikon-Systems 310 abgewichen.

Gemäß der anhand von Fig. 2 und Fig. 3a-3b beschriebenen Ausführungsform ist grundsätzlich aufgrund der beschriebenen Funktionsweise der variablen (Vorschalt-)Optik keine Verschiebung des berührungslosen Sensors 330 relativ zum optischen Element 301 zur Ermittlung einer räumlich variierenden Temperaturverteilung erforderlich. Es kann jedoch zusätzlich zu der vorstehend beschriebenen optischen Realisierung einer Variation des vom jeweiligen berührungslosen Sensor erfassten Strahlungsbereichs eine Manipulation der Relativposition zwischen dem jeweiligen optischen Element und dem berührungslosen Sensor vorgenommen werden. Hierzu zeigen Fig. 4 bis Fig. 6 mögliche Ausführungsformen.

Gemäß Fig. 4a bis 4c erfolgt jeweils ein bezogen auf ein hinsichtlich seines Erwärmungszustandes zu vermessendes optisches Element 401 bis 403 seitliches bzw. laterales Bewegen eines berührungslosen Sensors 430 (bezogen auf das eingezeichnete Koordinatensystem in x-Richtung), wobei sich diese Ausführungsformen hinsichtlich der konkreten Ausgestaltung einer dem Sensor 430 zugewandten (Rück-) Seite des jeweiligen optischen Elements bzw. Spiegels 401-403 voneinander unterscheiden. Konkret weist das optische Element 401 eine schräge Bohrung 401a, das optische Element 402 eine schräge Fräsung 402a und das optische Element 403 eine kreisförmige Aussparung 403a auf.

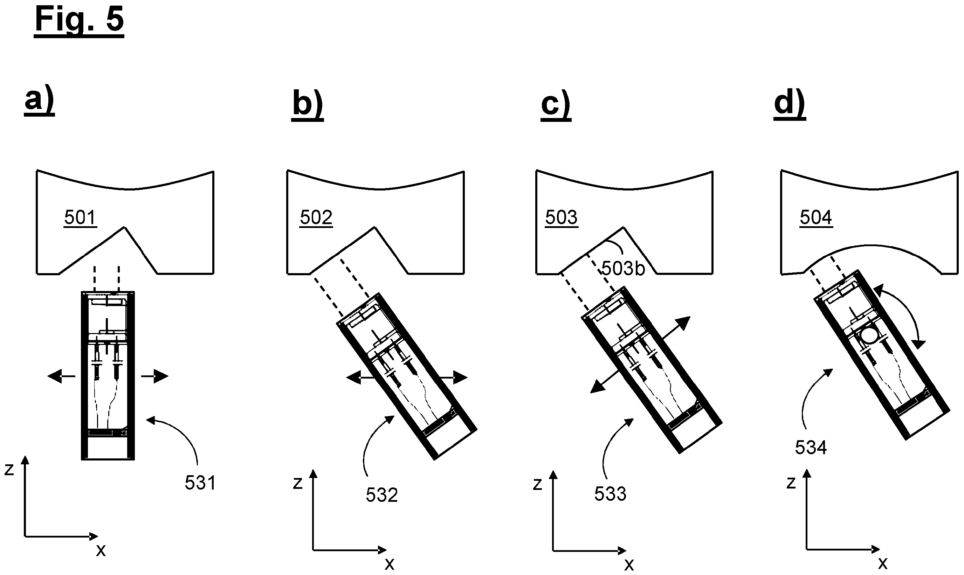

Fig. 5a bis 5d zeigen weitere beispielhafte Ausführungsformen einer Relativbewegung zwischen berührungslosem Sensor 531, 532, 533 bzw. 534 und optischem Element 501, 502, 503, 504. Konkret erfolgt gemäß Fig. 5a ein Verschieben des Sensors 531 parallel zur dem Sensor 531 zugewandten Rückseite des optischen Elements 501 (bezogen auf das eingezeichnete Koordinatensystem in x-Richtung), gemäß Fig. 5b ein Verschieben des bezogen auf die x-Richtung geneigten Sensors 532 in x-Richtung, gemäß Fig. 5c ein Verschieben des Sensors 533 parallel zu einer Oberfläche 503b der in dem optischen Element 503 vorhandenen Vertiefung im optischen Element 503 und gemäß Fig. 5d eine Drehung des Sensors 534 um eine zur Rückseite des optischen Elements 504 bzw. zur y-Richtung im eingezeichnete Koordinatensystem parallele Achse.

In weiteren Ausführungsformen kann die vom hinsichtlich seines Erwärmungszustandes zu vermessenden optischen Element ausgehende Strahlung auch zusätzlich über einen oder mehrere seitlich (d.h. nicht der Rückseite des optischen Elements bzw. Spiegels zugewandte) berührungslose Sensoren erfasst werden.

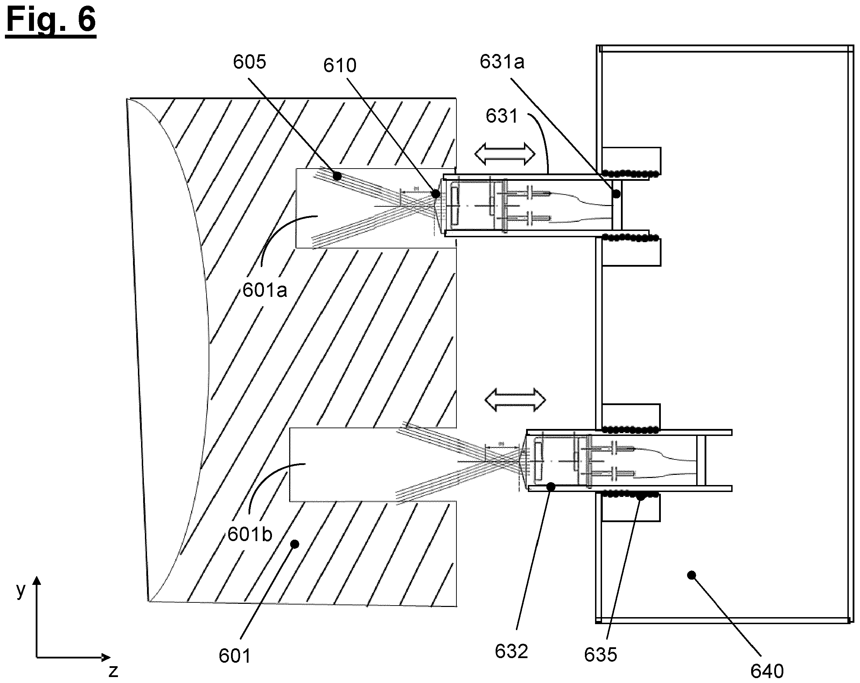

Fig. 6 zeigt in schematischer Darstellung eine weitere mögliche Ausführungsform.

Gemäß Fig. 6 sind zwei erfindungsgemäße berührungslose Sensoren 631, 632 bezogen auf ein hinsichtlich seines Erwärmungszustandes zu vermessendes optisches Element 601 über elektromechanische Aktoren 635 unabhängig voneinander axial verschieblich an einem als gekapselte Einheit ausgebildeten Gehäuse 640 vorgesehen. Die Verschiebung der Sensoren 631, 632, welche gemäß Fig. 6 an ein Elektronikboard 631a angeschlossen sind, erfolgt in jeweils am optischen Element bzw. Spiegel 601 vorhandenen Bohrungen 601a, 601b, wobei durch die axiale Verschiebung der vom jeweiligen Sensor 631 bzw. 632 erfasste Strahlungsbereich (mit "605" angedeutet) variiert werden kann. Diese mechanische Variation des erfassten Strahlungsbereichs kann zusätzlich zu dem Einsatz einer optischen Variation (wie z.B. der anhand von Fig. 2 bis 3 beschriebenen Vorschaltoptik) erfolgen.

Bei sämtlichen der vorstehend beschriebenen Ausführungsformen kann in der Praxis auch vorab eine Simulation durchgeführt werden, welche für bestimmte Einsatzszenarien des optischen Elements (z.B. bestimmte Bestrahlungssituationen eines Spiegels) das jeweils am berührungslosen Sensor bzw. Pyrometer zu erwartende (Überlagerungs-)Signal ergibt. Basierend auf dieser Simulation kann dann aus einem tatsächlich am berührungslosen Sensor erhaltenen Messsignal auf den Erwärmungszustand bzw. eine bestimmte Bestrahlungssituation geschlossen werden. Sodann kann auf Basis der Bestimmung des Erwärmungszustandes eine Vorheizung des optischen Elements zur wenigstens teilweisen Kompensation zeitlicher Änderungen des Erwärmungszustandes des optischen Elements durchgeführt werden.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

## Patentansprüche

1. Verfahren zum Bestimmen des Erwärmungszustandes eines optischen Elements in einem optischen System für die Mikrolithographie, wobei wenigstens ein berührungsloser, auf dem Empfang elektromagnetischer Strahlung von dem optischen Element (301, 401, 402, 403, 501, 502, 503, 504, 601) basierender Sensor (330, 430, 531, 532, 533, 534, 631, 632) verwendet wird, wobei zur Ermittlung einer Temperaturverteilung in dem optischen Element der von dem Sensor (330, 430, 531, 532, 533, 534, 631, 632) erfasste Strahlungsbereich variiert wird, **dadurch gekennzeichnet, dass** die Variation unter Verwendung einer zwischen dem optischen Element (301, 401, 402, 403, 501, 502, 503, 504, 601) und dem Sensor (330, 430, 531, 532, 533, 534, 631, 632) befindlichen Strahlformungsoptik erfolgt.

2. Verfahren nach Anspruch 1, **dadurch gekennzeichnet, dass** durch die Variation eine zonale Abtastung des optischen Elements (301, 401, 402, 403, 501, 502, 503, 504, 601) hinsichtlich der von diesem Element ausgehenden elektromagnetischen Strahlung realisiert wird.

3. Verfahren nach Anspruch 1 oder 2, **dadurch gekennzeichnet, dass** die Strahlformungsoptik ein Zoom-Axikon-System (210, 310) aufweist.

4. Verfahren nach einem der vorhergehenden Ansprüche, **dadurch gekennzeichnet, dass** die Variation eine Manipulation der Relativposition zwischen dem optischen Element (301, 401, 402, 403, 501, 502, 503, 504, 601) und dem Sensor (330, 430, 531, 532, 533, 534, 631, 632) umfasst.

5. Verfahren nach einem der vorhergehenden Ansprüche, **dadurch gekennzeichnet, dass** das optische Element (301, 401, 402, 403, 501, 502, 503, 504, 601) auf der dem Sensor (330, 430, 531, 532, 533, 534, 631, 632) zugewandten Seite wenigstens eine Aussparung oder Vertiefung und/oder wenigstens eine erhabene Struktur aufweist.

6. Verfahren nach einem der vorhergehenden Ansprüche, **dadurch gekennzeichnet, dass** als Sensor (330, 430, 531, 532, 533, 534, 631, 632) ein Pyrometer verwendet wird.

7. Verfahren nach einem der vorhergehenden Ansprüche, **dadurch gekennzeichnet, dass** das optische Element (301, 401, 402, 403, 501, 502, 503, 504, 601) ein Spiegel ist.

8. Verfahren nach einem der vorhergehenden Ansprüche, **dadurch gekennzeichnet, dass** das optische Element für eine Arbeitswellenlänge von weniger als 30nm, insbesondere weniger als 15nm, ausgelegt ist.

9. Verfahren nach einem der vorhergehenden Ansprüche, **dadurch gekennzeichnet, dass** auf Basis der Bestimmung des Erwärmungszustandes eine Vorheizung des optischen Elements zur wenigstens teilweisen Kompensation von im Betrieb des optischen Systems auftretenden zeitlichen Änderungen des Erwärmungszustandes des optischen Elements (301, 401, 402, 403, 501, 502, 503, 504, 601) und/oder eine Kompensation von durch den Erwärmungszustand im optischen System hervorgerufenen optischen Aberrationen durchgeführt wird.

10. Verfahren nach einem der vorhergehenden Ansprüche, **dadurch gekennzeichnet, dass** die Bestimmung des Erwärmungszustandes während des Betriebs des optischen Systems durchgeführt wird.

11. Verfahren nach einem der vorhergehenden Ansprüche, **dadurch gekennzeichnet, dass** das optische System eine mikrolithographische Projektionsbelichtungsanlage ist.

12. Optisches System für die Mikrolithographie, umfassend eine Vorrichtung zum Bestimmen des Erwärmungszustandes eines optischen Elements, mit
• wenigstens einem berührungslosen, auf dem Empfang elektromagnetischer Strahlung von dem optischen Element (301, 401, 402, 403, 501, 502, 503, 504, 601) basierenden Sensor (330, 430, 531, 532, 533, 534, 631, 632); und
• einer Einrichtung zur Variation des von dem Sensor (330, 430, 531, 532, 533, 534, 631, 632) erfassten Strahlungsbereichs;
**dadurch gekennzeichnet, dass** die Vorrichtung dazu konfiguriert ist, ein Verfahren nach einem der Ansprüche 1 bis 11 durchzuführen.

## Claims

1. Method for determining the heating state of an optical element in a microlithographic optical system, wherein use is made of at least one contactless sensor (330, 430, 531, 532, 533, 534, 631, 632) which is based on the reception of electromagnetic radiation from the optical element (301, 401, 402, 403, 501, 502, 503, 504, 601), wherein the radiation range captured by the sensor (330, 430, 531, 532, 533, 534, 631, 632) is varied for the purposes of ascertaining a temperature distribution in the optical element, **characterized in that** the variation is implemented using a beam shaping optical unit situated between the optical element (301, 401, 402, 403, 501, 502, 503, 504, 601) and the sensor (330, 430, 531, 532, 533, 534, 631, 632) .

2. Method according to Claim 1, **characterized in that** the variation realizes zonal sensing of the optical element (301, 401, 402, 403, 501, 502, 503, 504, 601) in respect of the electromagnetic radiation emanating from this element.

3. Method according to Claim 1 or 2, **characterized in that** the beam shaping optical unit comprises a zoom-axicon system (210, 310).

4. Method according to any one of the preceding claims, **characterized in that** the variation comprises a manipulation of the relative position between the optical element (301, 401, 402, 403, 501, 502, 503, 504, 601) and the sensor (330, 430, 531, 532, 533, 534, 631, 632).

5. Method according to any one of the preceding claims, **characterized in that** the optical element (301, 401, 402, 403, 501, 502, 503, 504, 601) has at least one cutout or depression and/or at least one elevated structure on the side facing the sensor (330, 430, 531, 532, 533, 534, 631, 632) .

6. Method according to any one of the preceding claims, **characterized in that** a pyrometer is used as the sensor (330, 430, 531, 532, 533, 534, 631, 632).

7. Method according to any one of the preceding claims, **characterized in that** the optical element (301, 401, 402, 403, 501, 502, 503, 504, 601) is a mirror.

8. Method according to any one of the preceding claims, **characterized in that** the optical element is designed for an operating wavelength of less than 30 nm, in particular less than 15 nm.

9. Method according to any one of the preceding claims, **characterized in that**, on the basis of the determination of the heating state, there is preheating of the optical element for the at least partial compensation of changes of the heating state of the optical element (301, 401, 402, 403, 501, 502, 503, 504, 601) over time, which occur during the operation of the optical system, and/or a compensation of optical aberrations caused by the heating state in the optical system.

10. Method according to any one of the preceding claims, **characterized in that** the heating state is determined during the operation of the optical system.

11. Method according to any one of the preceding claims, **characterized in that** the optical system is a microlithographic projection exposure apparatus.

12. Microlithographic optical system, comprising an apparatus for determining the heating state of an optical element, comprising
• at least one contactless sensor (330, 430, 531, 532, 533, 534, 631, 632) which is based on the reception of electromagnetic radiation from the optical element (301, 401, 402, 403, 501, 502, 503, 504, 601); and
• a device for varying the radiation range captured by the sensor (330, 430, 531, 532, 533, 534, 631, 632);
**characterized in that** the apparatus is configured to carry out a method according to any one of Claims 1 to 11.

## Revendications

1. Procédé de détermination de l'état d'échauffement d'un élément optique dans un système optique pour la microlithographie, au moins un capteur (330, 430, 531, 532, 533, 534, 631, 632) sans contact, basé sur la réception du rayonnement électromagnétique de l'élément optique (301, 401, 402, 403, 501, 502, 503, 504, 601) étant utilisé, la plage de rayonnement détectée par le capteur (330, 430, 531, 532, 533, 534, 631, 632) étant variée en vue de déterminer une distribution de la température dans l'élément optique, **caractérisé en ce que** la variation s'effectue en utilisant une optique de mise en forme de rayon qui se trouve entre l'élément optique (301, 401, 402, 403, 501, 502, 503, 504, 601) et le capteur (330, 430, 531, 532, 533, 534, 631, 632).

2. Procédé selon la revendication 1, **caractérisé en ce qu'**un palpage zonal de l'élément optique (301, 401, 402, 403, 501, 502, 503, 504, 601) pour ce qui concerne le rayonnement électromagnétique émis par cet élément est réalisé par la variation.

3. Procédé selon la revendication 1 ou 2, **caractérisé en ce que** l'optique de mise en forme de rayon possède un système de zoom axicon (210, 310).

4. Procédé selon l'une des revendications précédentes, **caractérisé en ce que** la variation comprend une manipulation de la position relative entre l'élément optique (301, 401, 402, 403, 501, 502, 503, 504, 601) et le capteur (330, 430, 531, 532, 533, 534, 631, 632).

5. Procédé selon l'une des revendications précédentes, **caractérisé en ce que** l'élément optique (301, 401, 402, 403, 501, 502, 503, 504, 601) possède, sur le côté faisant face au capteur (330, 430, 531, 532, 533, 534, 631, 632), au moins un évidement ou un creux et/ou au moins une structure en relief.

6. Procédé selon l'une des revendications précédentes, **caractérisé en ce que** le capteur (330, 430, 531, 532, 533, 534, 631, 632) utilisé est un pyromètre.

7. Procédé selon l'une des revendications précédentes, **caractérisé en ce que** l'élément optique (301, 401, 402, 403, 501, 502, 503, 504, 601) est un miroir.

8. Procédé selon l'une des revendications précédentes, **caractérisé en ce que** l'élément optique est conçu pour une longueur d'onde de travail de moins de 30 nm, notamment de moins de 15 nm.

9. Procédé selon l'une des revendications précédentes, **caractérisé en ce qu'**un préchauffage de l'élément optique en vue d'une compensation au moins partielle des variations dans le temps de l'état d'échauffement de l'élément optique (301, 401, 402, 403, 501, 502, 503, 504, 601) qui se produisent en fonctionnement du système optique et/ou d'une compensation des aberrations optiques provoquées dans le système optique par l'état d'échauffement est effectué sur la base de la détermination de l'état d'échauffement.

10. Procédé selon l'une des revendications précédentes, **caractérisé en ce que** la détermination de l'état d'échauffement est effectuée pendant le fonctionnement du système optique.

11. Procédé selon l'une des revendications précédentes, **caractérisé en ce que** le système optique est un équipement d'éclairage par projection pour le microlithographie.

12. Système optique pour la microlithographie, comportant un arrangement de détermination de l'état d'échauffement d'un élément optique, comprenant
* au moins un capteur (330, 430, 531, 532, 533, 534, 631, 632) sans contact, basé sur la réception du rayonnement électromagnétique de l'élément optique (301, 401, 402, 403, 501, 502, 503, 504, 601) ; et
* un dispositif destiné à faire varier la plage de rayonnement détectée par le capteur (330, 430, 531, 532, 533, 534, 631, 632) ;
**caractérisé en ce que** l'arrangement est configuré pour mettre en œuvre un procédé selon l'une des revendications 1 à 11.
